(19) **Europäisches Patentamt**

**European Patent Office**

**Office européen des brevets**

(11) **EP 1 017 092 A1**

(12) **EUROPEAN PATENT APPLICATION**

(43) Date of publication:
**05.07.2000 Bulletin 2000/27**

(51) Int. Cl.⁷: **H01L 21/3205**, **H01L 21/266**

(21) Application number: **98830797.1**

(22) Date of filing: **29.12.1998**

(84) Designated Contracting States:
**AT BE CH CY DE DK ES FI FR GB GR IE IT LI LU MC NL PT SE**
Designated Extension States:
**AL LT LV MK RO SI**

(71) Applicant:
**STMicroelectronics S.r.l.**
**20041 Agrate Brianza (Milano) (IT)**

(72) Inventor: **Santangelo, Antonello**
**95032 Belpasso (Catania) (IT)**

(74) Representative: **Botti, Mario**
**Botti & Ferrari S.r.l.**
**Via Locatelli, 5**
**20124 Milano (IT)**

(54) **Process for manufacturing a resistive structure used in semiconductor integrated circuit**

(57) Process for manufacturing a resistive structure (1) comprising at least one semiconductor strip (2) laid above a semiconductor substrate (3) characterised in that it comprises the following steps of:

- covering with a mask (4) said semiconductor strip (2);

- forming a plurality of apertures (5) in said mask (4) until portions (6) of the semiconductor strip (2) are uncovered;

- implanting dopant in said semiconductor strip (2) through said apertures (5);

- subjecting the resistive structure (1) to a thermal process for diffusing the dopant in such a way to obtain a variable concentration profile in the semiconductor strip (2).

Fig. 1

**Description**

Field of application

The present invention relates to a process for manufacturing a resistive structure used in semiconductor integrated circuits.

More specifically, the invention relates to a process for manufacturing a resistive structure comprising at least one semiconductor strip above a semiconductor substrate.

In particular, but not exclusively, the invention relates to a process for manufacturing a resistive structure for applications in radio-frequency and the following description is made with reference to this field of application with the only purpose of simplifying the exposure.

Prior art

As is well known, in the manufacturing of integrated circuits passive components are often used, such as the resistors that are formed by means of polysilicon strips, which lay above a semiconductor substrate. The polysilicon may be in case doped.

These resistors have often to be characterised by values of resistivity comprised within a range of values which can extend for about five orders of magnitude (10 ohm- 1 Mohm), and in particular in the applications at high frequency it is important that they have a reduced parasitic capacitance with respect to the substrate.

Anyway, as these components use only one substrate of polysilicon of a predetermined resistivity, their size cannot be optimised with respect to the parasitic components.

In fact if for the manufacturing of resistors, a low conductivity material is used, in order to obtain high resistance values, it will be necessary to manufacture a component having a minimum width but a considerable length.

Further on, if the resistive component has to subject high current densities, it will be necessary then to increase the width and length of such component, in order to obtain the required resistance value.

A first known technical solution, for satisfying the requirement of manufacturing in a single integrated circuit resistors of different resistance values, is that of forming polysilicon strips, whose doping is formed by means of successive implantation steps with different doses, protecting from time to time some strips of polysilicon, by means of a lithographic process.

In particular, by means of a first ion implantation process, all the polysilicon strips that will be used for manufacturing the resistive structures, are doped. This first process is carried out with a dose of dopant necessary for obtaining the resistive structures with the highest value.

By means of a subsequent lithographic process, the polysilicon strips, which will constitute the resistive structures with the highest value, are masked and the remaining ones will be exposed to a second implantation process. This process, in conjunction with the above process, allows the formation of a resistive structure with a lower value.

Using a further ion implantation process and another photolithographic process, it is possible to obtain strips of polysilicon with three different values of resistivity.

It is then possible to use the strips at lower resistivity to form the resistor at lower resistance and those at high resistivity for those at high resistance.

The portions of the passive component that are needed for the interconnection with the usual level of metalization are normally subjected to all ion implantation processes in order to minimise the contact resistance between the polysilicon and the metal.

Further on, if, in order to better control the resistivity of the polycrystalline silicon, at the time of the formation of the resistors semiconductor, regions are provided on the surface of the integrated circuit, which are not "homologous" to the species to be implanted, it may be then necessary to using of a further photolithographic process that protects said surface portions. In fact, it will be necessary to "mask" such regions during the first ion implantation process and during the following ones, in order to avoid a partial or total compensation of the dopant species present therein, which would affect negatively the contact resistance with respect to the metalization.

Although advantageous in some aspects, this solution needs different masking steps in order to form these passive components, increasing the complexity of the manufacturing process and its costs.

The technical problem at the basis of the present invention is that of obtaining a process for manufacturing polysilicon resistors in a only lithographic and ion implantation step, in such a way to obtain semiconductor regions of different resistivity, having such functional features to minimise the process steps needed for forming these resistors, without loosing in flexibility and overcoming the drawbacks that to date limit the processes formed according to the prior art.

Summary of the invention.

The solving idea at the basis of the present invention is that of manufacturing a mask that has apertures, with the purpose of masking some portions of the same polysilicon strip during the implantation step. A subsequent thermal treatment allows to use the side diffusion of the dopant inside the semiconductor material for obtaining high resistivity values with respect to resistors that are not subjected to any protection during the ion implantation.

On the basis of such solving idea, the technical problem is solved by a process of the abovementioned type and defined by the characterising part of claim 1.

The features and the advantages of the process according to the invention will result from the following description of an embodiment thereof which is reported for indicative and non limiting purposes, with reference to the attached drawings.

Brief description of the drawings:

In such drawings:

- figure 1 shows a schematic perspective view of a semiconductor portion on which a resistive structure is formed, using of the process according to the invention;

- figures 2 and 3 show respective enlarged views in vertical section of a portion of a semiconductor substrate during the development of a process of manufacture according to the invention;

- figure 4 shows a diagram wherein the active boron concentration inside the polycrystalline resistive structure versus the length of the structure itself is reported.

Detailed description.

With reference to such figures, it is now described a process for manufacturing resistive structures 1 used in semiconductor integrated circuits.
The process steps described hereinbelow do not form a complete process flow of a process for the manufacture of integrated circuits. The present invention can be practiced together with the manufacturing techniques for integrated circuits which are applied at the moment in the field, and only those process steps are enclosed, which are commonly used and which are necessary for understanding the present invention.
The description of the proposed process is based on the drawings which illustrate cross sections of integrated circuit portions during the manufacturing steps and they are not drawn in scale, but just in a way to illustrate the essential features of the invention.
The first step of the process for manufacturing resistive structures 1 foresees the formation of a layer of dielectric 3a on a semiconductor substrate 3. Above the dielectric layer 3a, the deposition of a semiconductor layer 2a is foreseen, in particular of polycrystalline silicon.
By means of a conventional photolithographic step an etching of the polysilicon layer 2a is carried out, in order to define at least one elongated strip 2 of polysilicon of width W.
Advantageously, a second strip 20 is defined in the same polysilicon layer 2a.

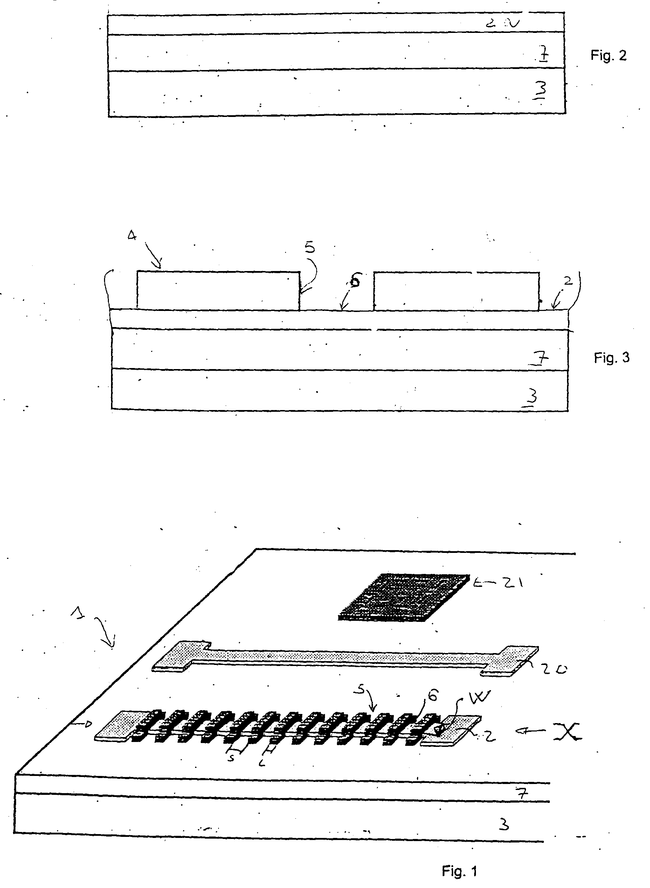

At this point, a photoresist mask 4 is formed to cover the strip 2 of polysilicon.
Whenever a contact region 21 is present, the mask 4 may advantageously cover also this last, as shown in figure 1.
Therefore, apertures 5 in the mask 4 are formed, until portions 6 of the strip 2 are uncovered.
The form of such apertures can take different geometries. For example, square apertures may be provided which are arranged in a "chessboard" structure or aligned in rows and columns.
Apertures 5 may be rectangular, triangular, circular or of any plan geometrical shape.
In order to make the illustration easier, rectangular apertures 5 are taken into consideration, which have greater width than the width W of the polysilicon strip 2.
Advantageously, such apertures 5 occur over the entire length of the polysilicon strip 2.
In this embodiment, the portions 6 of the polysilicon strip 2, which are covered by the mask 4 take the form of parallel tracks and the open mask 4 has a substantially striped aspect.
The apertures 5 obtained in the mask 4 are determined by two geometrical parameters, S and L, wherein parameter S represents the length in the longitudinal direction X of the strip 2 and parameter L represents the distance that occurs between two subsequent apertures.
An ion implantation step, for example the implantation of $BF_2^+$ ion, allows to dope with boron only the parts of the strip 2 which are left exposed by the mask 4.
After the removal of the mask 4, the structure 1 is subjected to a thermal process that has the purpose of activating and diffusing the dopant inside the polysilicon strip 2.
As the implanted species diffuse in all directions, by suitably varying the geometrical parameters L and S, it is possible to obtain a resistive strip 2 that compared to the unmasked strip 20 has a lower average dopant concentration, and therefore a higher resistance value.
If the two geometrical parameters S and L are the same, and the species diffusion is such to obtain a constant doping profile along the longitudinal direction x of the resistive strip 2, a dopant concentration that is about the half of that of the resistive strip 20, that has no masking, and a value of layer resistance which is about twice are respectively obtained
If the dimension S is reduced to the limits given by the photolithographic technique, and the distance L is increased, compatibly with the side diffusion of the implanted dopant, average dopant concentrations may be achieved that are still lower.
As in the polycrystalline materials, the dopant diffusion length $L_D = 2 * (D*t)^{1/2}$ - wherein D is the diffusivity of the species implanted in the semiconductor, and t is the diffusion time - is greater than that of corresponding monocrystalline materials, the dimension L may advantageously greater than that which would be necessary in a monocrystalline material.

This allows to obtain an average dose $Dm = (S/(S+L))*Ds$, wherein Ds is the value of the implanted dose, that is substantially lower than the implanted dose; this happens also if thermal processes are used at temperatures and for times which are lower than those that would be necessary for the monocrystalline semiconductors.

The dopant distribution along the X direction of the polysilicon strip is in this way substantially uniform and allows to obtain a high resistivity material with respect to the resistors that are implanted on the entire surface area.

If the diffusion length is lower than the dimension L, high resistivity regions are obtained, which alternate with more conductive regions.

This allows to obtain a polycrystalline material that has an average resistivity higher than in case of an uniformly distributed dopant (Ld>>L).

It is further known that, in the case of doping with boron, the lower the dopant concentration the more remarkable the change in resistivity with temperature; when the dopant concentration is reduced to values lower than $5*10^{13}$ cm$^{-3}$, an unexpected increase of resistivity is noticed that can bring about drawbacks.

The use of polycrystalline materials, in particular polysilicon, is therefore preferred because it allows the use of lower S/(S+L) ratios with a more uniform dopant distribution, thanks to the high diffusivity of the dopants.

Hereinbelow a non limitative example of a process is disclosed, which allows the formation of two semiconductor strips formed according to the invention and to the prior art.

Two strips 2, 20 formed of polysilicon are defined with a thickness of 2000 Å.

A photoresist layer with a thickness of about 5000 Å is deposed in order to form the mask 4 on the strip 2 and apertures 5 are obtained whose geometric parameters S and L are 0.5 μm and 1 μm, respectively.

A $BF_2^+$ ion implantation is carried out at an energy of 50 KeV and with a dose of $4,5 \cdot 10^{15}$ cm$^{-2}$ and, once the mask 4 is removed, a layer of oxide is formed and an annealing at 900 °C for 15 minutes in $N_2$ is carried out.

Then, in a conventional way, the steps of opening and defining the contacts for the connection to the metallizing layer follow.

With such operational sequence, resistive strips 20 of about 170 Ohm/square and resistive strips 2 partially protected during the implantation, that reach a value of about 1 kOhm/square may be obtained.

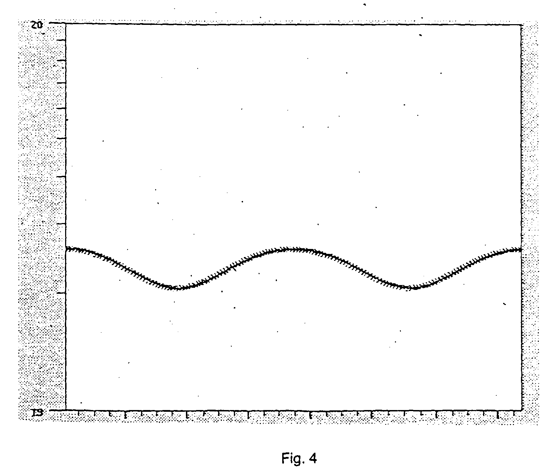

In figure 4, data relative to a bidimensional simulation of a section of the resistive strips carried out along the longitudinal direction X of the component 2 are reported, wherein on the y-axis the concentration of active boron inside the polycrystalline silicon and on the x-axis the length of the polysilicon strip 2 are respectively reported, when apertures 5 are formed, whose geometrical dimensions are L = 1 μm and S = 0,5 μm.

From this diagram, it results that the concentration of dopant inside the polycrystalline silicon implanted with the process according to the invention is lower than that which would occur if the mask 4 was not formed.

Eventually, if other electronics components already present on the integrated circuit are compatible with thermal processes at higher temperatures and for longer times, it is obviously possible to further increase the parameter L and to obtain more uniform dopant profiles.

In conclusion, the choice of a specific geometry for the apertures 5 of the mask 4 depends upon the purpose of obtaining, after the thermal process required for activating and diffusing the dopant, an average concentration of the implanted species which is substantially lower than the polysilicon strips that are not shielded during the implantation.

**Claims**

1. Process for manufacturing a resistive structure (1) comprising at least one semiconductor strip (2) laid above a semiconductor substrate (3) characterised in that it comprises the following steps of:

   - covering with a mask (4) said semiconductor strip (2);

   - forming a plurality of apertures (5) in said mask (4) until portions (6) of the semiconductor strip (2) are uncovered;

   - implanting dopant in said semiconductor strip (2) through said apertures (5);

   - subjecting the resistive structure (1) to a thermal process for diffusing the dopant in such a way to obtain a variable concentration profile in the semiconductor strip (2).

2. Process according to claim 1, characterised in that said semiconductor strip (2) is formed of polysilicon.

3. Process according to claim 1 or 2, characterised in that said apertures (5) are rectangular.

4. Process according to claim 3, characterised in that said apertures (5) are formed over the entire length of the polysilicon strip.

5. Process according to claim 4, characterised in that said mask (4) has a substantially striped aspect.

6. Process according to claim 2, characterised in that said apertures (5) are square.

7. Process according to claim 6, characterised in that said apertures (5) are arranged according to chessboard-like arrangement.

8. Process according to claim 6, characterised in that said apertures (5) are aligned in rows and columns.

9. Process according to claim 2, characterised in that said apertures (5) have a triangular or rectangular or circular shape.

10. Process according to any of the preceding claims, characterised in that the concentration profile of the semiconductor strip (2) is uniform.

Fig. 2

Fig. 3

Fig. 1

Fig. 4

European Patent Office

## EUROPEAN SEARCH REPORT

Application Number

EP 98 83 0797

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | US 4 672 738 A (STENGL REINHARD ET AL) 16 June 1987 * column 2, line 45 - column 5, line 3; figures 1,2 * | 1,3,6,7 | H01L21/3205 H01L21/266 |
| A | EP 0 400 934 A (GEN ELECTRIC) 5 December 1990 * abstract; figure 3 * | 1 | |
| A | US 4 411 708 A (WINHAN LUCIEN C) 25 October 1983 * abstract * | 1 | |
| A | US 5 462 889 A (TSUKADA MICHIKO ET AL) 31 October 1995 * abstract; figure 8 * | | |

| | |
|---|---|
| | TECHNICAL FIELDS SEARCHED (Int.Cl.6) |
| | H01L |

The present search report has been drawn up for all claims

| Place of search | Date of completion of the search | Examiner |
|---|---|---|
| THE HAGUE | 27 May 1999 | Königstein, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 98 83 0797

This annex lists the patent family members relating to the patent documents cited in the above-mentioned European search report.
The members are as contained in the European Patent Office EDP file on
The European Patent Office is in no way liable for these particulars which are merely given for the purpose of information.

27-05-1999

| Patent document cited in search report | | Publication date | Patent family member(s) | | Publication date |
|---|---|---|---|---|---|
| US 4672738 | A | 16-06-1987 | EP | 0176778 A | 09-04-1986 |
| | | | JP | 1881234 C | 21-10-1994 |
| | | | JP | 6003799 B | 12-01-1994 |
| | | | JP | 61084830 A | 30-04-1986 |
| EP 0400934 | A | 05-12-1990 | US | 4927772 A | 22-05-1990 |
| | | | DE | 69027630 D | 08-08-1996 |
| | | | DE | 69027630 T | 13-02-1997 |
| | | | JP | 3094469 A | 19-04-1991 |
| US 4411708 | A | 25-10-1983 | NONE | | |
| US 5462889 | A | 31-10-1995 | JP | 5198747 A | 06-08-1993 |
| | | | JP | 5183110 A | 23-07-1993 |
| | | | DE | 69222393 D | 30-10-1997 |
| | | | DE | 69222393 T | 02-04-1998 |
| | | | EP | 0541122 A | 12-05-1993 |

EPO FORM P0459

For more details about this annex : see Official Journal of the European Patent Office, No. 12/82